Europäisches Patentamt

European Patent Office

Office européen des brevets

(11) Publication number: **0 088 912**
**A2**

## EUROPEAN PATENT APPLICATION

(21) Application number: **83101700.9**

(22) Date of filing: **22.02.83**

(51) Int. Cl.³: **H 01 L 27/06**
**G 11 C 11/40**

(30) Priority: **15.03.82 US 357944**
**02.07.82 US 394573**

(43) Date of publication of application:
**21.09.83 Bulletin 83/38**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Chatterjee, Pallab K.**
**1107 Haynes Drive**
**Richardson Texas 75081(US)**

(72) Inventor: **Shah, Ashwin H.**
**10114 Desert Willow**
**Dallas Texas 75243(US)**

(74) Representative: **Leiser, Gottfried, Dipl.-Ing. et al,**
**Patentanwälte Prinz, Bunke & Partner Ernsberger**
**Strasse 19**
**D-8000 München 60(DE)**

(54) Subthreshold load element for static ram cell.

(57) A transistor operated in the subthreshold regime, e.g., a thick field parasitic FET, is utilized as a load element to maintain the state of a static RAM cell. The RAM cell is constructed with minimum spacing between devices to insure that the subthreshold current of the parasitic FET is sufficient to hold the memory state of the cell. This provides a useful purpose for a device characteristic (subthreshold leakage) that previously caused a problem in the increased isolation requirements; and additionally provides a major density improvement in SRAM cells.

Fig. 2

EP 0 088 912 A2

Croydon Printing Company Ltd.

## BACKGROUND AND SUMMARY OF THE INVENTION

This invention relates to static RAM cells in general, and in particular to the high impedance load elements required to maintain the state of a static RAM cell.

In high-speed static RAMs, the load element has been either MOS transistors or extremely high resistance polysilicon resistors. For MOS load transistors, the holding current in the static memory with conventional depletion loads (i.e., with depletion mode MOS load transistors) is usually quite large when estimated on the scale required for meeting the power budget of dense memories. Thus, for a 100 mw power dissipation within an array of a 4K static RAM operating with a 5V supply, the holding current per cell, i.e., the load current per cell, must be approximately 5. ua. To obtain this load or holding current with depletion load devices, which have current gains of approximately 20 to 30 ua per square volt, the width to length ration (W/L) must be substantially less than one (1) and the threshold voltage ($V_T$) must approach zero volts.

For example, a threshold voltage of approximately -1 V would require a W/L of 1/20 or more in order to restrict the static latch current to within the power budget. Since the area of a cell is limited by the width to length ration (W/L), and the minimum width (W) is generally dictated by the moat feature which is approximately 1.5 to two (2) times the minimum gate length, a small W/L device will occupy a very large area. In other words, any power savings from geometric optimization in such a cell would be offset by the cost of an increase in area.

In static RAM cells wherein the load element is an extremely high resistance polysilicon resistor, such resistors reduce the power consumed by the memory cell to very low levels; and they also provide a physically smaller cell (thereby allowing more cells to be placed on a single die or bar). Undoped or lightly doped polysilicon load resistors may be obtained by tailoring the resistivity of the polysilicon through an ion implantation process, and such polysilicon load memory cells have been widely utilized. These types of cells, however, add extra steps to the manufacturing, i.e., masking operation, in order for the mask count for the polysilicon resistor load memory cell process to remain the same as for the depletion load memory cell if the cell load implant is customized.

In other words, although the extremely high resistance polysilicon resistor load memory cells have the disadvantage of extra manufacturing steps, they provide or produce a smaller area memory cell having a high impedance which permits a power savings by lowering the holding current required to maintain the static latch in a bistable state.

One of the major problems associated with polysilcon load resistors, however, is that conduction in the polysilicon can occur through the gain boundaries thereof, causing the resistivity of the load element to vary in an uncontrolled manner. This is a very serious problem for it severely limits the reliability and controllability of polysilicon resistor load memory cells. Moreover, the static latch of these conventional static RAM cells produces leakage current which exponentially increases with the ambient temperature of the memory cell. This leakage current is not compensated for by the polysilicon load resistors.

It is a principal objective of the subject invention to provide a low power static random access memory (RAM) cell for supplying sufficient subthreshold load current to hold the static latch in a bistable state. It is a further objective of the subject invention to provide a low power static random access memory cell for supplying subthreshold load current which exponentially increases with ambient temperature thus offsetting any increase in the leakage current of the static latch. Another objective of the subject invention is to provide sufficient subthreshold holding currrent to offset, (i.e. to temperature track) any leakage current through the coupling or access elements of the memory cell. A still further objective of the subject invention is to provide a low power static random access memory cell which requires one less masking operation, i.e., manufacturing step, than conventional depletion load memory cells. Yet another objective of the subject invention is to provide a low power static random access memory cell which requires two fewer masking operations, i.e,, manufacturing steps, than conventional polysilicon resistor load memory cells. Moreover, another objective of the subject invention is to provide sufficient subthreshold holding current to offset the leakage current produced by any source/drain diode effects in the memory cell. A further objective of the subject invention is to provide a load element having a threshold voltage which is lower than the threshold voltage of the active elements in the static latch and coupling access elements of the cell.

In accordance with the subject invention, a low power static random access memory (RAM) cell is provided, which includes driver means for providing regenerative feedback; access means for electrically coupling the driver means to a random access memory (RAM) array; and natural load means for supplying subthreshold holding current to the driver means.

The low power static RAM cell is powered by the subthreshold current of the natural load means. This subthreshold current provides sufficient power to hold the driver means in a bistable state when the cell is in the store mode and is also capable of automatically compensating for leakage current variances caused by changes in the ambient temperature of the cell.

A specific emobodiment of the subject invention has driver means, such as a pair of cross-coupled enhancement mode field effect transistors (FET), for providing the regenerative feedback; access means, such as two complementary enhancement mode field effect transistors (FET), for electrically coupling the driver means to the random access memory (RAM) array; and natural load means, such as two enhancement threshold field effect transistors (FET), having a threshold voltage lower than that of the driver means and the access means, for supplying subthreshold holding current to the driver means.

The low power static memory cell is implemented with metal oxide semiconductor (MOS) technology, Schottky barrier semiconductor (MES) technology, or the like. The input and output voltages of the subject invention are compatible with the input and output voltages of conventional logic circuits.

It is therefore an object of this invention to provide a static RAM cell which makes use of a previously problematic parasitic current to replace a component, thus saving space required for the cell. It is another object of this invention to provide a static RAM cell which has a greater packing density. Yet another object of this invention is to provide a cell having a simplified fabrication process.

In one aspect of the invention, there is provided a static RAM cell comprising a cross-coupled flip-flop circuit. The load element, in each leg of the flip-flop, for developing the voltage signals to maintain the cell state, consists of a parasitic FET which is a by-product of recently developed high-density fabrication techniques. These techniques moved device elements closer together, and resulted in parasitic currents flowing between adjacent elements. In the present invention, current that flows in a parasitic FET is made use of as a load for driver FET of a static RAM cell. The subthreshold current that flows in these parasitic devices is determined by the spacing dimension between adjacent moats. This dimension is set according to what is required in order for the parasitic current to be sufficient to maintain the cell state. The voltage-current function of the parasitic FET is slightly different than the natural FET in that the shorter channel length causes some non-linearity. At lower values of voltage, current increase in relation to voltage increase is slightly less than exponential up to a point, and then increases to an approximate square-law relationship as the upper operating limit is approached. This parasitic thick-field FET is automatically fabricated in known FET processes, including MOSFET and MESFET. In another aspect of the invention there is provided a static RAM cell having a much greater packing density resulting from the absence of two semiconductor load resistors and the closer spacing of devices.

BRIEF DESCRIPTION OF THE DRAWINGS

Figure 1 is a cross-sectional view of a device showing the parasitic thick-field FET.

Figure 2 is a plot of the turn-off characteristics of a natural device and two thick field devices showing the current relationship to the gate-source voltage.

Figure 3 is an expanded view of the device of Figure 1.

Figure 4 is a schematic diagram of a RAM cell including the present invention.

Figure 5 is a composite drawing of the mask set for fabrication of a SRAM cell of the present invention.

Figure 6 is a drawing of the moat mask of a SRAM cell of the present invention.

Figure 7 is an electrical schematic diagram of a low power static RAM cell made in accordance with the subject invention;

Figure 8 is an electrical equivalent schematic diagram of a portion of the natural load means and driver means of the low power static RAM cell illustrated in Figure 7; and

Figure 9 is a semi-logarithmic graph of the subthreshold load characteristics of the equivalent circuit illustrated in Figure 8.

DESCRIPTION OF THE PREFERRED EMBODIMENTS

As used in this description and in the appended claims, the phrase "natural load" means a load having a threshold voltage that is lower than the threshold voltage of the driver means, and the access means.

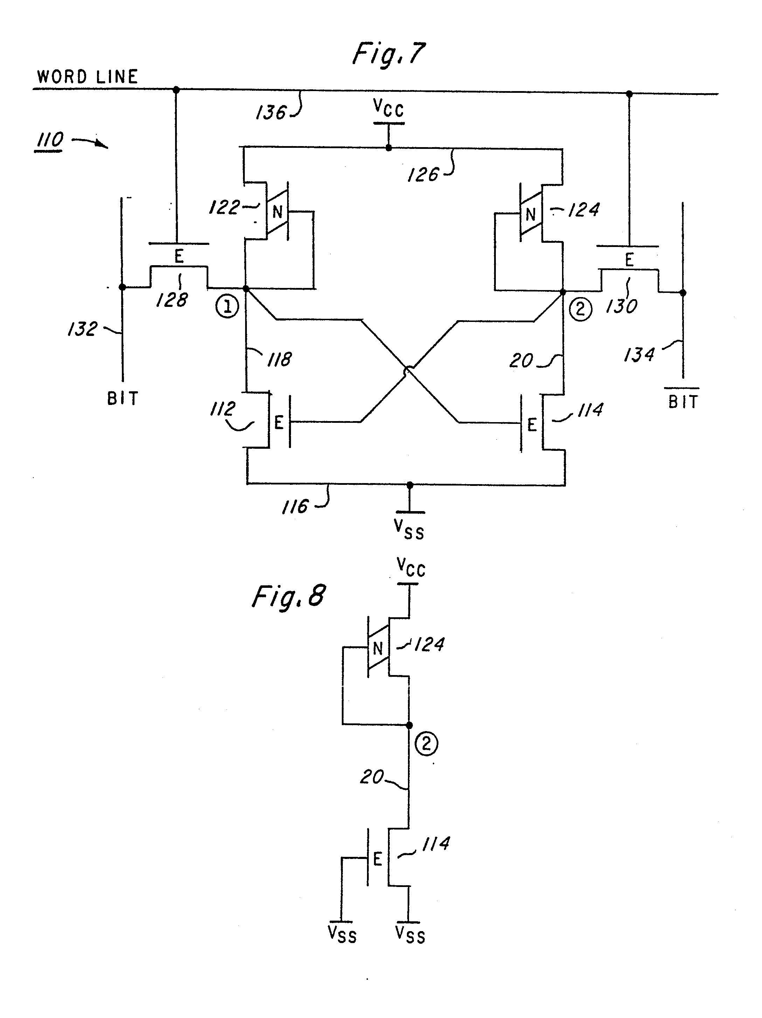

Referring to Figure 7, a low power static random access memory (RAM) cell in accordance with the subject invention is generally shown at 110. The low power static random access memory (RAM) cell 110 comprises driver means, such as the pair of cross-coupled enhancement mode field effect transistors (FET) 112 and 114, which have a common source region 116 connected to ground or a source voltage supply $(V_{SS})$. The drain 118 and 120, respectively, of each of the cross-coupled transistors 112 and 114, respectively, is connected to the gate of the opposite cross-coupled transistor, providing a regenerative feedback circuit, i.e., the well known "static latch". No load resistors of a conventional type are used. Instead, the low power static random access memory (RAM) cell 110 comprises natural load means, i.e., load means having a lower threshold voltage than that of the driver means and access means, such as the pair of relatively low enhancement threshold field effect transistors (FET) 122 and 124, which have a common drain region 26 connected to a drain voltage supply $(V_{CC})$. The gate and source of natural load transistor 122 is connected to Node 1 of the driver means, i.e., the static latch, and the source and gate of natural load transistor 124 is connected to Node 2 of the driver means. The natural load means supplies subthreshold load or holding current to the driver means. The static RAM cell 110 also comprises access means, such as the pair of enhancement mode field effect transistors (FET) 128 and 130, which have a common gate region 136 connected to the word data line of a random access memory (RAM) array. The source of the access or coupling transistor 128 is connected to Node 1 of the driver means, and the source of the access or coupling transistor 130 is connected to Node 2 of the driver means. The drain of transistor 128 is connected to the bit data line 132, and the drain of transistor 130 is connected to the bit bar data line 134, i.e., the complement 134 of the bit data line 132.

When in the store operational mode, the static RAM cell 110 power is supplied by the natural load transistors 122 and 124 via their subthreshold current. During cell operation, the subthreshold current produced by the natural load means, i.e., the natural load transistors 122 and 124, provides sufficient power to hold the driver means in a bistable state.

In other words, during cell operation, when the threshold voltage ($V_T$) of the natural load transistors 122 and 124 is approximately 0.1 to 0.2 volts and their width to length (W/L) ratio is approximately one, the load or holding current supplied is approximately 10 to 20 nano amps. If the threshold voltage ($V_T$) of the driver means, i.e., the cross-coupled enhancement mode field effect transistors 112 and 114, is approximately $0.5 \pm 0.1V$, the ratio of on to off currents in the cell 110 will track the exponential difference in their $V_T$; since in the subthreshold region, the current is exponential in gate voltage. Thus, the difference in on to off currents for a 300 mv threshold voltage ($V_T$) differential will be approximately $10^3$ or $10^4$ assuming 80 to 100 mv per decade subthreshold slope.

In other words, it should be appreciated by those of ordinary skill in the art that the load or holding current will always exceed the leakage current according to the ratio:

$$\Delta V_T = V_{TE} - V_{TN}, \text{ where}$$

$V_{TE}$ is the threshold voltage of the enhancement mode driver transistor 112 and 114,

$V_{TN}$ is the threshold voltage of the natural load transistors 122 and 124, and

$\Delta V_T$ is the threshold voltage difference between the two.

It should be further appreciated by those of ordinary skill in the art that this ratio which is locked into the difference in the threshold voltages of the natural load means and the driver means will track the leakage current of the driver means, the source/drain diodes, and the access means, as the leakage current varies with ambient temperature.

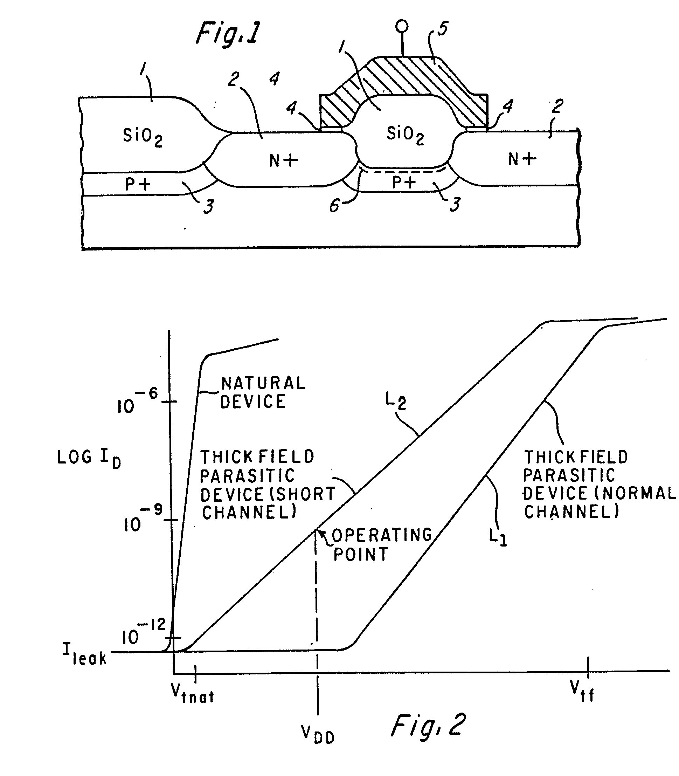

It should also be appreciated by those persons of ordinary skill in the art that since the natural load transistors 122 and 124 are connected as source followers, the subthreshold currrent of the natural load means will decrease as the source voltage thereof is increased. Furthermore, when in the low power static RAM cell 110, as best illustrated in Figure 1, one node, such as for example, Node 1, is at the source supply voltage ($V_{SS}$), the other node, e.g., Node 2, will be at a high voltage that is determined by the load line characteristics of the natural load means and the driver means. It should be appreciated that the gate of the driver transistor 114 is biased at the source supply voltage ($V_{SS}$). Thus, the subthreshold load characteristics that determine the high voltage can be determined by reference to the equivalent circuit which is best illustrated in Figure 2.

Referring now to Figure 2; the driver transistor 114 has an enhancement threshold voltage ($V_{TE}$), and the natural load transistor 124 has a natural threshold voltage ($V_{TN}$). The high voltage ($V_{HI}$) can, therefore, be determined when:

$$V_{TE} \ (V_{BS} = 0) = V_{TN} \ (V_{BS} = V_{HI}) - (1);$$

where, $V_{HI}$ is the stored high voltage, $V_{BS}$ is the substrate base voltage, and $V_{TE}$ and $V_{TN}$ are, respectively, the enhancement and natural threshold voltages.

It should, of course, be apparent to those persons of ordinary skill that the high voltage ($V_{HI}$) will be maximized if the body effect of the natural load transistor 124 is minimized. In short channel MESFET and MOSFET devices, the body effect is reduced due to the two-dimensional sharing of the gate charge with the source and drain. This reduction in body effect is substantially improved when the junction depth is increased for a given channel length. Since most static RAM manufacturing processes provide a deep junction to realize low resistance interconnect, the natural load transistor 124 can be defined with deeper source/drain junctions to maximize the high voltage/level in the cell.

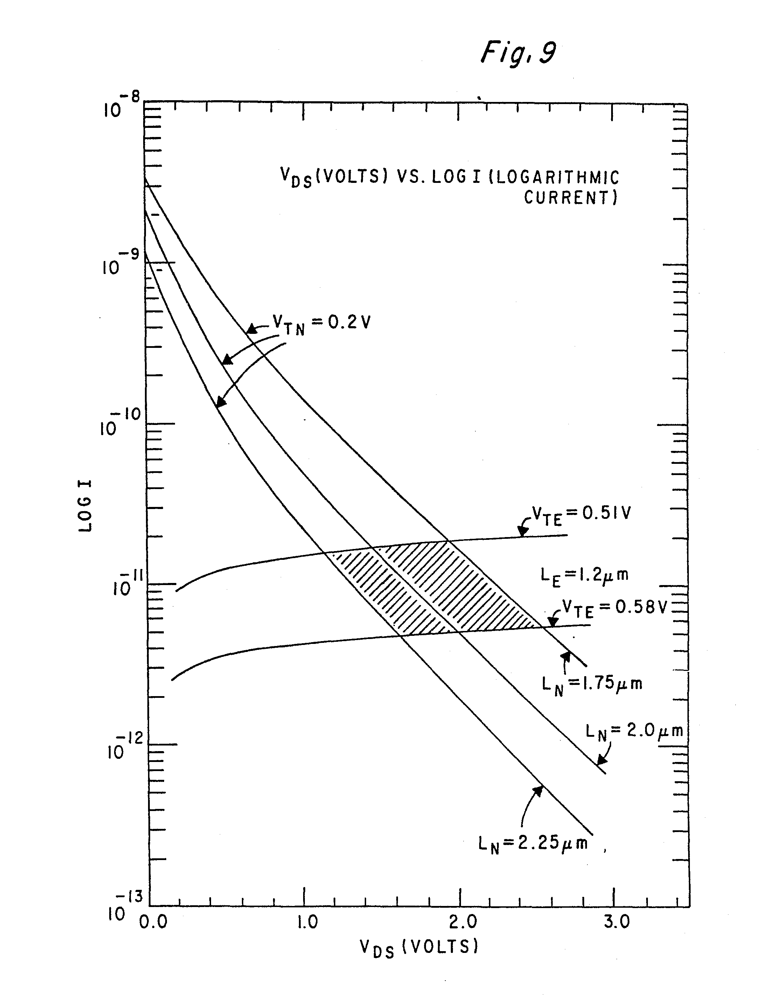

The subthreshold load characteristics of the equivalent circuit illustrated in Figure 8, are best illustrated in semilogarithmic form in Figure 9. The effect of variations in the manufacturing process upon the subthreshold load characteristics are also illustrated in Figure 9. The shaded or hatched area in Figure 9, illustrates the acceptable operating zone or window of the $V_{HI}$ for the low power static RAM cell 110 of the subject invention. This operational zone or range is wide enough to make practical applications and manufacture of the subject invention feasible.

Referring now to the manufacturing process; the natural load static RAM cell 110 of the subject invention requires one less masking operation than the conventional depletion load static RAM cell process. The subject invention provides precision control of the subthreshold currents in the cell merely by setting the threshold voltages ($V_T$) of the natural load transistors 122 and 124, and the driver transistors 112 and 114 through the technique of ion implantation. The memory cell area of the subject invention is substantially reduced compared to depletion load memory cells since width to length ratios approximately equal to one (1) may be used for the natural load means as compared to width to length ratios approximately equal to one (1) may be used for the natural load means as compared to width to length ratios of approximately 1/10 or more for depletion load memory cells. There are two first contacts required in the natural load memory cells, this feature is common to depletion and polysilicon resistor load memory cells as well. The grain boundary diffusion problem and the grain size control requirement of polysilicon resistor load means is avoided; so that the processing, i.e., the manufacturing, need only concentrate on the active elements in the memory cell.

It should be appreciated by those persons of ordinary skill in the art that a static RAM cell made in accordance with the subject invention is at least as compact as a polysilicon resistor load static RAM cell. It should further be appreciated by those persons that a cell made in accordance with the subject invention is subject to more precise operational control, and has substantial tolerance to leakage current and ambient temperature variations.

Another preferred embodiment of the invention, using a parasite thick-field FET as the load element for an SRAM cell, will now be discussed in detail.

Referring now to Figure 1, there is shown a cross-sectional view of the n-channel parasitic device of the present invention. The natural FET (which is not shown) is formed by the n+ regions 2, gate oxide 4, and gate 5. The parasitic FET conducts current through a region 6 close to the surface of the P+ region 3. The thick field oxide areas 1 allow this parasitic current, and thereby the parasitic FET load element is possible.

The process for fabrication of the device as shown in Figure 1 begins with a P-type substrate 8. On the substrate is deposited a layer of $SiO_2$ having a thickness in the range of 300 to 1000 A. Over the $SiO_2$ is now deposited a layer of $Si_3N_4$ having a thickness in the range of 700-2000 A. Over the $Si_3N_4$ is deposited a pattern of photoresist material for protection of the active device areas while the balance of the $Si_3N_4$ is etched away. The resist is then stripped, leaving an oxide/nitride stack over the device areas and oxide on the remaining surface. A P+ implant is done at this point. The preferred dopant level is from $10^{12}$ to $5 \times 10^{13}/cm^2$, at an energy level of 100-150 Kev. The thick field oxide areas are now grown, the thickness being in the range 3000 A to 1.5 microns. The nitride and oxide are now removed from the areas of the active devices, or alternatively this may be done after the n+ implant, the next step in the process. The n+ implant has a preferred dopant level of $10^{16}/cm^2$, with an energy level of approximately 50 Kev. Then, a thin oxide is grown over the n+ implant areas, having a thickness of from 100 to 300 A. The gate electrode is now deposited, preferably polysilicon, about .5 microns in thickness. Interconnections are then made between the devices and calls on the chip to form the complete array.

Figure 2 shows the relationship of the turnoff characteristics of a natural FET and two parasitic FETs, both standard spacing (moat-to-moat) L1, and the shortened channel L2 of the present invention. The plot shows the log of the drain current versus the gate-to-source voltage. The natural device has a very sharp turnoff compared to the thick field devices, the turnoff rate being about 80-100 mw per decade for the natural device, and about 1-2 volts per decade for the thick field devices. Generally, the spacing for the moat-to-moat minimum dimension is selected so that, when the gate of the thick-field device is tied to $V_{dd}$, the conduction in the thick field device is comparable to the reverse junction current leakage of the device. This is done by increasing the channel length of the parasitic thick field device so that isolation requirements for that situation can be met. In the present invention, the moat-to-moat spacing is decreased which shifts the turn-off characteristics of the device so that the subthreshold current at $V_{GS}=V_{DD}$ is significantly higher than the junction leakage.

However, the current magnitude is greatly reduced form the levels associated with the high speed polysilicon load resistor. The 'constant current generator' configuration of the parasitic FET load tends to be more stable in current and voltage drops. Also, the polysilicon resistor might, in some cases, intersect grain boundaries and cause the resistance to vary uncontrollably.

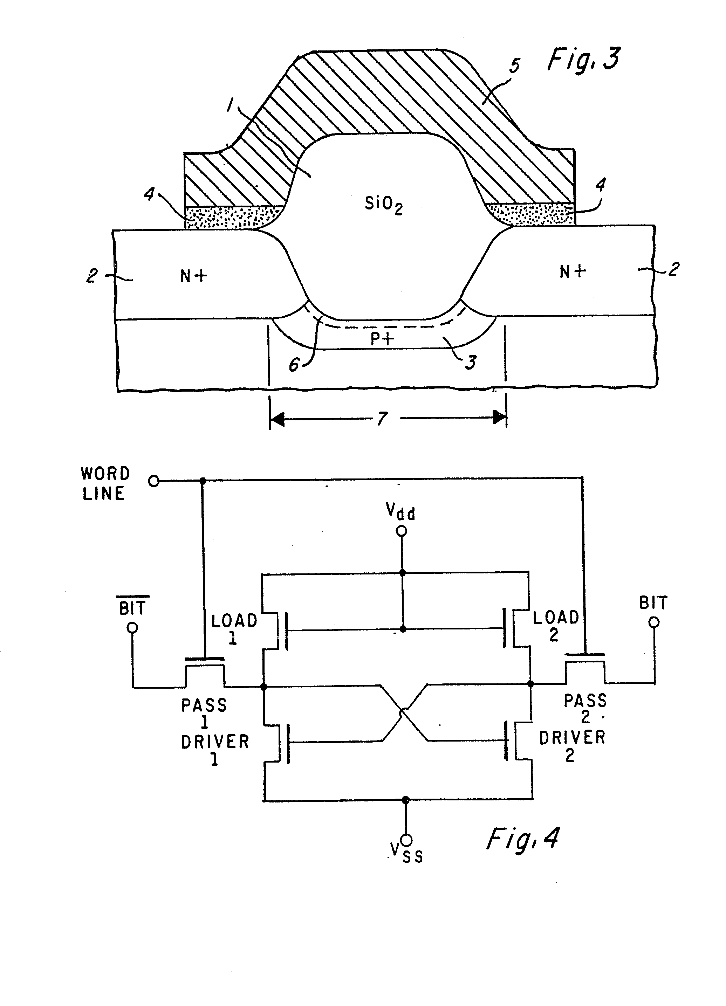

Figure 3 is an expanded version of the drawing in Figure 1, making more clear the components of the invention. The thick field oxide 1 separates the poly gate 5 from the channel stop region 3. The gate oxide 4 insulates the gate 5 from the n+ source/drain regions 2. The parasitic device channel region 6 is at the surface of the channel region 3. The moat-to-moat spacing 7 determines the turn-off characteristics of the thick field device.

The schematic drawing in Figure 4 shows the circuit arrangement of a preferred embodiment of the present invention, which is a PMOS array fabricated by an N-well CMOS process. This implementation allows the basic sense signal to be developed at or near $V_{SS}$ rather than $V_{DD}$, as in the case of the nMOS embodiment, thus making sensing the signal much easier.

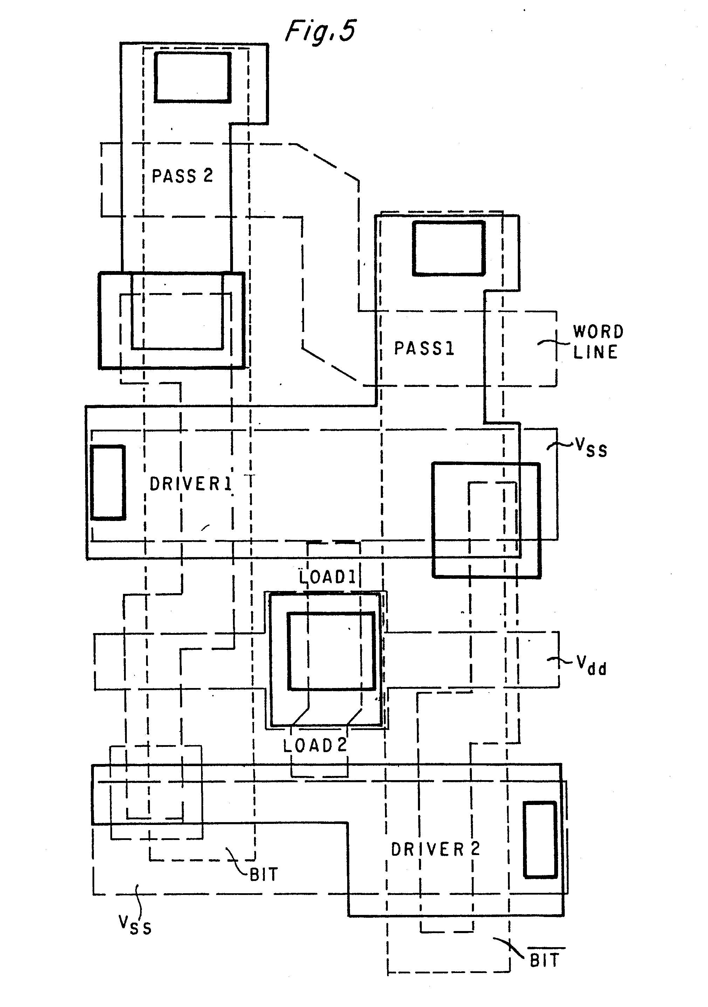

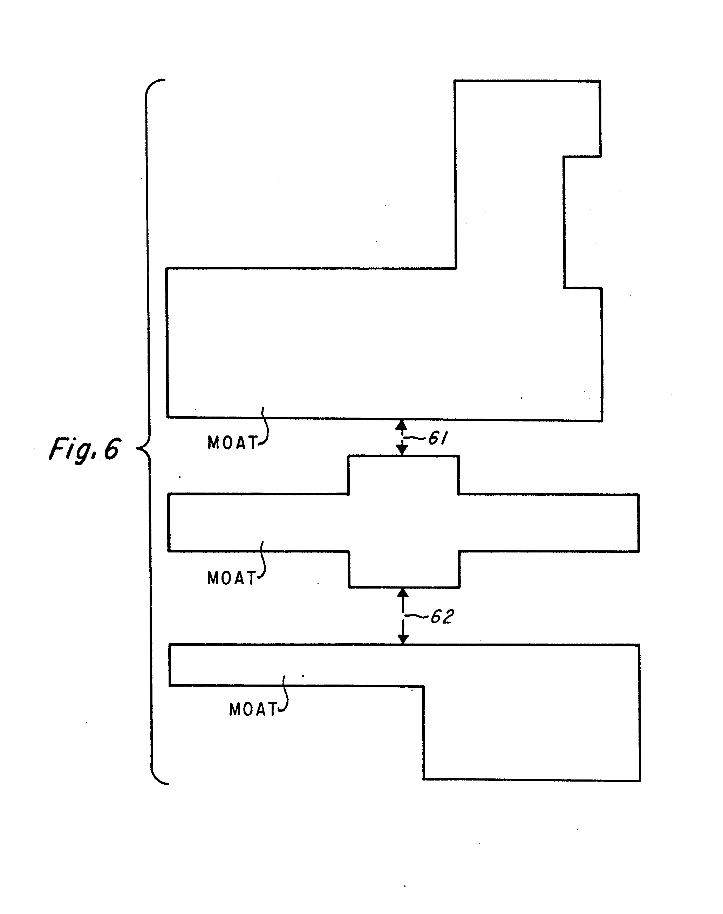

Figure 5 is a drawing showing a top view of the process mask set for the SRAM cell of the present invention. Although the top view does not show the obvious interconnection of the different levels, the device areas in the cell are labeled, and this labeling is consistent with the labeling of the schematic in Figure 4. Figure 6 shows the moat mask only, to indicate the spacing dimension as desired that is adjusted to set the subthreshold parasitic current. The moat-to-moat spacing 61 and 62 determines the current flowing in the parasitic FET load. The minimum current for this load is set by the diode junction leakage, which is about a pico-ampere. To maintain the state of the cell, the current in the load should be preferably 10 times the junction leakage current. Therefore the minimum load current should be about $10^{-11}$ amperes. The maximum current is set by the power dissipation·tolerable in the array. For a large array, a typical limit would be 50 mW, which translates into individual load device current of $10^{-7}$ maximum. To compensate for temperature variations the maximum current is set at about $10^{-9}$ amps to stay within the power budget at high temperatures. Therefore, the range of current for the load FET is preferably $10^{-9}$ amps to $10^{-11}$ amps. This translates to about 3-4 volts range required for the thick fluid parasitic device to maintain the current which will hold the cell state.

Other applications for this parasitic load are nMOS circuitry, where certain circuit nodes need to be fixed at a predetermined level without adverse effect on the circuitry. The very high impedance presented by this parasitic current load (1 to 10 Gigohms) can maintain a node potential without damping signal characteristics of a circuit containing such a fixed level node.

Additionally, some possibilities exist for use of the parasitic load of the present invention in analog circuitry. Where linearity is a non-critical parameter, this load may be useful, as the non-linearity of the device is not such a major problem as to limit use to only very narrow sets of parameter specifications. For instance, the parasitic load is more linear than the typical depletion mode transistor.

The advantage of this invention is mainly the deletion of the polysilicon load resistor, and the accompanying saving of chip real estate. This saving of space significantly enhances the packing density of an array using this cell, and the fabrication process is simplified by removal of the steps required for deposition and doping the polysilicon for load resistors.

While the invention has been described in detail with respect to illustrative embodiments, it will be apparent to those skilled in the art that various changes can be made without departing from the spirit or scope of the invention.

WHAT IS CLAIMED IS:

1. A low power static random access memory cell, comprising:

(a) cross-coupled drivers for providing regenerative feedback;

(b) access means for electrically coupling said drivers to a random access memory array; and

(c) field-effect transistor load for supplying holding current to said drivers;

characterized in that said transistor load is connected to operate in the subthreshold regime thereof.

2. A memory cell as set forth in Claim 1, wherein said transistor load is a thick field parasitic FET device.

3. A memory cell as set forth in Claim 1, wherein said drivers and said access means comprise enhancement mode field effect transistors.

4. A memory cell as set forth in Claim 3, wherein said transistor load comprises enhancement threshold field effect transistors having a threshold voltage lower than said driver means and said access means.

5. A memory cell as set forth in Claim 1, wherein said load means includes means for providing sufficient subthreshold load current to hold said driver means in a bistable state when in the store mode.

6. A memory cell as set forth in Claim 7, wherein said natural load means includes means for substantially reducing the short channel body effect of said transistor load.

7. A cell as set forth in Claim 4, wherein at least one of said enhancement threshold field effect transistors comprises a deep source/drain diode junction.

8. A cell as set forth in Claim 4, wherein at least one of said enhancement threshold field effect transistors comprises a deep level donor ion implanted impurity.

9. The cell of Claim 1, wherein said transistor load comprises a natural load element.

10. A RAM array comprising a plurality of cells as in Claim 1.

11. A memory cell as in Claim 1, wherein the channel length of said parasitic FET load element is selected to achieve a desired load current.

12. A memory cell as in Claim 1, having a P-well CMOS configuration.

13. A load element for semiconductor integrated circuit, comprising a thick-field parasitic FET device, said device having a short channel length for establishment of a predetermined device current level.

14. The load element of Claim 13, said device being defined by spacing of moat regions of natural devices such that current flows at a level usable for a high-impedance load.

Fig.1

Fig. 2

Fig. 3

SiO$_2$

4

N+   2

2   N+

P+

6   3

7

WORD LINE

V$_{dd}$

$\overline{BIT}$

LOAD 1

LOAD 2

BIT

PASS 1
DRIVER 1

PASS 2
DRIVER 2

V$_{ss}$

Fig. 4

*Fig.5*

PASS 2

PASS1

WORD LINE

$V_{ss}$

DRIVER 1

LOAD 1

$V_{dd}$

LOAD 2

DRIVER 2

BIT

$V_{ss}$

$\overline{BIT}$

Fig. 6

MOAT

~61

MOAT

~62

MOAT

*Fig.7*

*Fig.8*

*Fig. 9*